Europäisches Patentamt

European Patent Office

Office européen des brevets

(19)

(11) Numéro de publication : **0 156 146**
**B1**

(12)

# FASCICULE DE BREVET EUROPÉEN

(45) Date de publication du fascicule du brevet :
17.08.88

(21) Numéro de dépôt : 85101537.0

(22) Date de dépôt : 13.02.85

(51) Int. Cl.⁴ : **H 03 H   9/10, G 04 F   5/06**

(54) **Oscillateur piézo-électrique.**

(30) Priorité : 15.02.84 CH 730/84

(43) Date de publication de la demande :
02.10.85 Bulletin 85/40

(45) Mention de la délivrance du brevet :
17.08.88 Bulletin 88/33

(84) Etats contractants désignés :
DE FR GB

(56) Documents cités :
FR-A- 2 336 806
FR-A- 2 461 404
FR-A- 2 482 784
GB-A- 2 002 955
US-A- 3 073 975
PATENTS ABSTRACTS OF JAPAN, vol. 6, no. 72 (E-
105)(950), 7 mai 1982, page 5 E 105; & JP - A - 57 10
513 (CITIZEN TOKEI K.K.) 20-01-1982

(73) Titulaire : ASULAB S.A.
Faubourg du Lac 6
CH-2501 Bienne (CH)

(72) Inventeur : Zingg, Walter
Rue des Mornets 11
CH-2520 La Neuveville (CH)

(74) Mandataire : Gresset, Jean et al
ICB Ingénieurs Conseils en Brevets SA Passage
Max. Meuron 6
CH-2001 Neuchâtel (CH)

## Description

La présente invention se rapporte aux oscillateurs piézo-électriques comportant un élément piézo-électrique et un boîtier. Elle concerne, plus particulièrement, un oscillateur, tel que définit dans le préambule de la revendication 1.

Un tel oscillateur est décrit dans la demande de brevet anglais GB-A-2 002 955. Dans cette demande, le boîtier comporte deux plaques dont l'une au moins est en quartz. Cette dernière est munie d'un piédestal tenant lieu d'assise à l'élément piézo-électrique et revêtu de pistes conductrices. Elle est percée d'un trou qui débouche sur l'une de ces pistes conductrices. Ce dernier est obturé au moyen de soudure. Des essais pratiques ont montré qu'il était difficile de garantir l'étanchéité de ce trou, ce qui détériore la qualité du vide de l'enceinte dans laquelle se trouve l'élément piézo-électrique et par là réduit considérablement la durée de vie de l'oscillateur.

Un but de la présente invention est de résoudre ce problème. Il est atteint par l'oscillateur objet de la revendication 1, grâce au fait que le trou est obturé de façon étanche par la piste conductrice.

Un autre but de la présente invention est de réduire le prix de revient de l'oscillateur. Ce but est atteint par l'oscillateur décrit à la revendication 2, plus particulièrement du fait que les plaques sont en verre.

Dans le cas du document cité plus haut, le quartz a été choisi pour la fabrication de l'une des plaques à cause de son anisotropie, ce qui permet de percer des trous quasi cylindriques par attaque chimique.

Dès lors que le trou est obturé après avoir été percé, une forme cylindrique est souhaitable pour garantir un bon contact entre la piste conductrice et la soudure d'obturation. Par contre, dans la solution revendiquée, les trous en forme de cratère, tels qu'on les obtient par attaque chimique du verre, facilitent le dépôt du métal. Cette solution permet donc d'éliminer le quartz qui, non seulement est plus couteux que le verre, mais qui de plus comporte des micro-veines qui permettent une légère diffusion de gaz, d'où l'impossibilité de garantir à long terme un vide satisfaisant dans le logement.

Un autre but de la présente invention est de réaliser un oscillateur comportant ses deux bornes sur la même face du boîtier. Ce but est atteint par l'oscillateur objet de la revendication 4. Un tel oscillateur permet un montage simplifié sur les circuits imprimés, du fait qu'il peut y être soudé sans qu'il soit nécessaire d'utiliser des pattes de connexion.

L'invention sera mieux comprise à la lecture de la description qui va suivre faite en regard des dessins annexés dans lesquels :

la fig. 1 représente une vue en coupe d'un oscillateur selon l'invention ;

la fig. 2 est une vue en plan de ce même oscillateur ; et

la fig. 3 illustre schématiquement différentes étapes de fabrication d'un tel oscillateur.

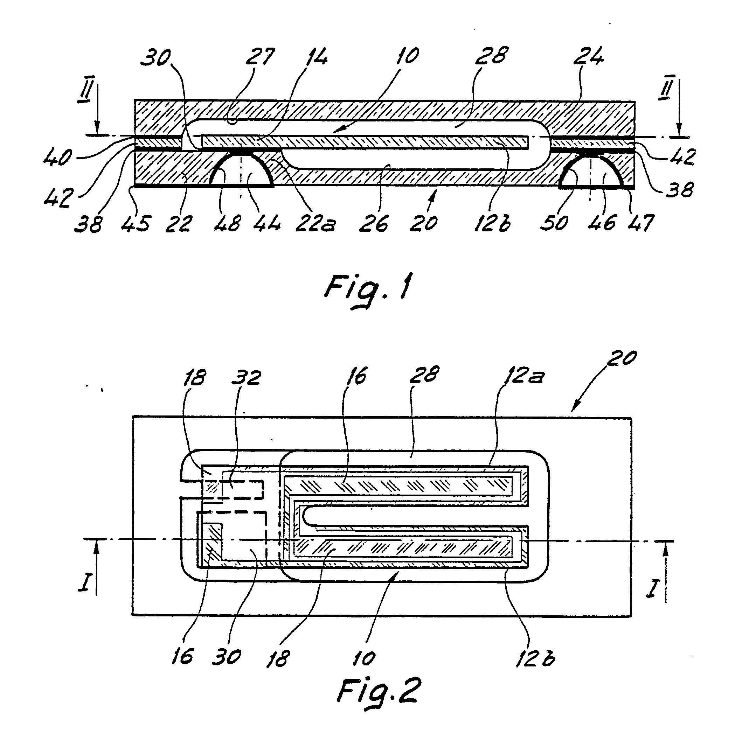

L'oscillateur représenté aux figures 1 et 2 comprend un élément piézo-électrique 10, en forme de diapason, dont les branches 12a et 12b et la base 14 portent des électrodes de commande 16 et 18. Il comprend en outre un boîtier parallélipipédique 20, fait de deux plaques 22 et 24 en matériau isolant, avantageusement en verre. Les faces internes de ces plaques possèdent des creusures 26 et 27 respectivement, qui définissent un logement 28. La partie 22a de la face interne de la plaque 22 tient lieu de piédestal au diapason. Elle porte des pistes conductrices 30 et 32, reliées électriquement aux électrodes 16 et 18, au moyen de deux points de colle conductrice ou de soudure non représentés. Ces points assurent en outre la fixation du diapason, par sa base 14, sur le piédestal 22a.

Les périphéries des faces internes de chacune des deux plaques 22 et 24 sont totalement revêtues par des pistes conductrices annulaires 38 et 40 en regard l'une de l'autre et séparées par un cadre de scellement 42, en alliage d'étain par exemple, qui assure la liaison entre les deux plaques. La piste 32 est, en fait, un prolongement de la piste annulaire 38.

La plaque inférieure 22 est percée de trous 44 et 46, en forme de cratère, l'un au droit du piédestal 22a, près d'une extrémité de la plaque, l'autre à l'extrémité opposée. Les trous ont été représentés seulement sur la fig. 1 pour ne pas altérer la lisibilité de la fig. 2. Les trous 44 et 46 sont respectivement obturés, de façon étanche, à leur extrémité intérieure, par les pistes conductrices 30 et 38, et contiennent des couches conductrices 48 et 50 respectivement, qui débordent sur la face externe de la plaque 22 pour constituer des bornes d'alimentation 45 et 47 respectivement de l'élément piézo-électrique 10.

Il faut relever que le trou 46 peut être placé n'importe où dans la zone occupée par la piste annulaire 38. Il est cependant avantageux de l'éloigner le plus possible du trou 44 afin de réduire les risques de court-circuit, notamment lors du montage du boîtier sur un circuit imprimé.

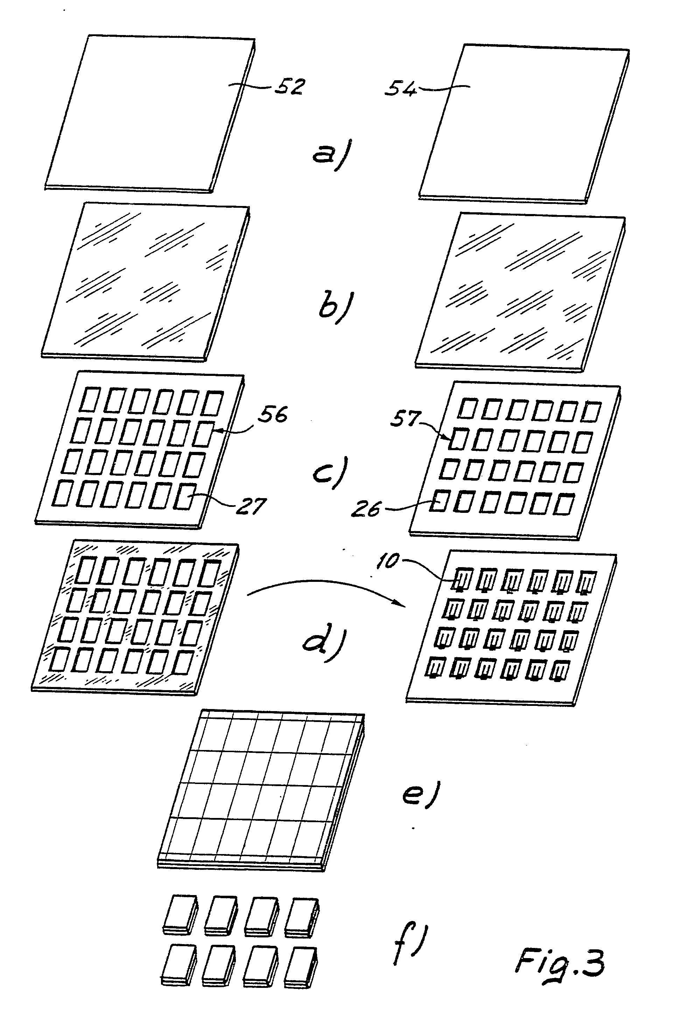

La figure 3 illustre de manière schématique différentes étapes de fabrication d'un tel oscillateur. On part de deux plaques de verre 52 et 54 (fig. 3a), de plusieurs centimètres de côté et d'épaisseur égale à l'épaisseur des plaques 22 et 24, que l'on métallise sur les deux faces (fig. 3b) en disposant tout d'abord une couche de chrome puis une couche d'or. Les plaques 52 et 54 sont alors gravées (fig. 3c) par attaque chimique pour obtenir des structures alvéolaires 56 et 57, dont chaque alvéole correspond respectivement aux creusures 27 et 26 du boîtier de la figure 1. Durant la même opération, on creuse en outre dans la plaque 54 les trous 44 et 46, non représentés sur la figure 3. Les couches métalliques initialement déposées sur les deux plaques sont ensuite attaquées chimiquement pour ne garder que les pistes conductrices 30, 32, 38, 40, 45 et 47. On colle alors un diapason 10, par sa base, sur le bord de chacune des alvéoles 57 de la plaque 54 (fig. 3d). Puis, après avoir déposé un cadre de soudure (correspondant au cadre 42 de la figure 1) autour de chaque alvéole 56, on place les deux plaques l'une sur l'autre (fig. 3e) de manière à ce que chaque creusure 27 coiffe un diapason 10. Le tout est ensuite chauffé sous vide pour réaliser la soudure des plaques l'une à l'autre.

Une fois les deux plaques assemblées, les couches métalliques 48 et 50 (fig. 1) sont déposées dans les creusures 44 et 46 respectivement. En variante, on peut remplir ces creusures au moyen d'un alliage à base d'étain ou de colle conductrice.

Pour terminer, les deux plaques sont rayées (fig. 3e) puis cassées selon les rayures de manière à séparer les oscillateurs (fig. 3f).

Il apparaît ainsi que l'invention permet la réalisation d'un boîtier parfaitement étanche, grâce au fait que le trou permettant la liaison électrique des pistes conductrices avec l'extérieur du boîtier est obturé par la piste elle-même, qui, bien que très mince, a une compacité suffisante pour garantir l'étanchéité.

## Revendications

1. Oscillateur piézo-électrique comportant :
— un élément piézo-électrique (10) qui porte des électrodes de commande (16, 18) ;
— un boîtier qui comporte des première (22) et deuxième (24) plaques en matériau isolant, accolées l'une à l'autre de façon étanche, et dont les faces internes possèdent des creusures (26, 27) définissant un logement (28) pour ledit élément ainsi qu'un piédestal (22a) lui servant de support et appartenant à la première plaque, ledit piédestal étant revêtu de pistes conductrices (30, 32) reliées électriquement auxdites électrodes, ladite première plaque étant en outre percée d'au moins un trou (44) qui débouche sur l'une des pistes conductrices (30) et contient un matériau conducteur (48) relié électriquement à cette piste, et une paire de bornes (45, 47) assurant la liaison électrique desdites pistes vers l'extérieur du boîtier, l'une d'elles au moins étant constituée par le matériau conducteur contenu dans ledit trou, caractérisé en ce que ledit trou est obturé de façon étanche par la piste conductrice sur laquelle il débouche.

2. Oscillateur selon la revendication 1, caractérisé en ce que le matériau isolant est du verre.

3. Oscillateur selon les revendications 1 ou 2, caractérisé en ce que le bord de la face interne de chacune desdites plaques porte une piste conductrice annulaire (38, 40) et en ce que ledit boîtier comporte, en outre, un cadre métallique (42) soudé auxdites pistes annulaires.

4. Oscillateur selon la revendication 3, caractérisé en ce que la première plaque est, en outre, percée d'un second trou (46) qui débouche sur ladite piste annulaire (38), laquelle l'obture de façon étanche et en ce que ce trou contient un matériau conducteur (50) qui constitue l'autre desdites bornes (47).

5. Oscillateur selon la revendication 4, caractérisé en ce que le second trou est percé dans l'extrémité opposée de la première plaque.

6. Oscillateur selon l'une des revendications 1 à 5, caractérisé en ce que le boîtier a une forme parallélipipédique.

7. Oscillateur selon l'une des revendications 1 à 6, caractérisé en ce que le matériau conducteur est constitué d'au moins une couche d'or qui recouvre les parois dudit trou.

8. Oscillateur selon l'une des revendications 1 à 6, caractérisé en ce que ledit matériau conducteur est constitué d'un alliage à base d'étain qui remplit entièrement ledit trou.

9. Oscillateur selon l'une des revendications 1 à 6, caractérisé en ce que le matériau conducteur est constitué de colle conductrice qui remplit ledit trou.

10. Oscillateur selon la revendication 2, caractérisée en ce que ledit trou a une forme de cratère dont l'ouverture la plus large se trouve sur la face externe de ladite première plaque.

## Claims

1. A piezoelectric oscillator comprising :
— a piezoelectric element (10) having control electrodes (16, 18) thereon ;
— a casing including first (22) and second (24) plates of insulating material that are sealed to one another and whose insides are formed with recesses (26, 27) providing a housing (28) for said element and defining an internal pedestal (22a) on the first plate supporting said element, said pedestal being coated with conductive tracks (30, 32) that are electrically connected to said electrodes, said first plate being further formed with at least one hole (44) opening on one of said conductive tracks (30) and containing a conductive material (48) electrically connected to said one track, and a pair of terminals (45, 47) for electrically connecting said tracks externally of the casing, at least one of said terminals being formed by the conductive material contained in said hole, characterized in that said hole is sealed by the conductive track on which it opens.

2. An oscillator as in claim 1, characterized in that the insulating material is glass.

3. An oscillator as in claim 1 or 2, characterized in that the edge of the inner surface of each of said plates bears an annular electrically conductive track (38, 40) and in that said casing further includes a metal frame (42) welded to said annular tracks.

4. An oscillator as in claim 3, characterized in that the first plate is further formed with a second hole (46) opening on and sealed by said annular track (38), and in that said hole contains a conductive material (50) forming the other of said terminals (47).

5. An oscillator as in claim 4, characterized in that the second hole is formed in the opposite end of the first plate.

6. An oscillator as in anyone of claims 1 to 5, characterized in that the casing is of parallelipipedic shape.

7. An oscillator as in anyone of claims 1 to 6, characterized in that the conductive material consists of at least a layer of gold coating the surfaces of said hole.

8. An oscillator as in anyone of claims 1 to 6, characterized in that the conductive material consists of a tin based alloy which entirely fills said hole.

9. An oscillator as in anyone of claims 1 to 6, characterized in that the conductive material consists of conductive adhesive material which fills said hole.

10. An oscillator as in claim 2, characterized in that said hole is crater shaped with its larger orifice opening in the outer surface of said first plate.

**Patentansprüche**

1. Piezo-elektrischer Oszillator, umfassend
— ein piezo-elektrisches Element (10), das Steuerelektroden (16, 18) aufweist ;
— ein Gehäuse, das eine erste (22) und eine zweite (24) Platte aus isolierendem Material umfaßt, die miteinander abgedichtet zusammengefügt sind und deren Innenseiten Ausnehmungen (26, 27) besitzen, welche eine Aufnahme (28) für das genannte Element sowie ein Piedestal (22a) begrenzen, das ihm als Support dient und zu der ersten Platte gehört, welches Piedestal mit Leiterbahnen (30, 32) beschichtet ist, die elektrisch mit den genannten Elektroden verbunden sind, wobei die genannte erste Platte ferner von mindestens einem Loch (44) durchbohrt ist, das auf einer der Leiterbahnen (30) mündet und ein leitendes Material (48) enthält, das elektrisch mit dieser Leiterbahn verbunden ist, und ein Paar von Anschlußklemmen (45, 47), die die elektrische Verbindung der genannten Leiterbahnen zum Äußeren des Gehäuses herstellen, von denen mindestens eine von dem in dem genannten Loch enthaltenen leitenden Material gebildet wird, dadurch gekennzeichnet, daß das genannte Loch abgedichtet durch die Leiterbahn verschlossen ist, auf die es mündet.

2. Oszillator nach Anspruch 1, dadurch gekennzeichnet, daß das isolierende Material Glas ist.

3. Oszillator nach Anspruch 1 oder 2, dadurch gekennzeichnet, daß der Rand der Innenseite jeder der genannten Platten eine ringförmige Leiterbahn (38, 40) trägt und daß das genannte Gehäuse ferner einen metallischen Rahmen (42) umfaßt, der mit den genannten ringförmigen Leiterbahnen verlötet ist.

4. Oszillator nach Anspruch 3, dadurch gekennzeichnet, daß die erste Platte ferner von einem zweiten Loch (46) durchbohrt ist, das auf der genannten ringförmigen Leiterbahn (38) mündet, welche es abgedichtet verschließt und daß dieses Loch ein leitendes Material (50) enthält, das die andere der genannten Klemmen (47) bildet.

5. Oszillator nach Anspruch 4, dadurch gekennzeichnet, daß das zweite Loch an dem entgegengesetzten Ende der Platte gebohrt ist.

6. Oszillator nach einem der Ansprüche 1 bis 5, dadurch gekennzeichnet, daß das Gehäuse eine parallelepipedische Form aufweist.

7. Oszillator nach einem der Ansprüche 1 bis 6, dadurch gekennzeichnet, daß das leitende Material von mindestens einer Goldschicht gebildet ist, die die Wandungen des genannten Loches bedeckt.

8. Oszillator nach einem der Ansprüche 1 bis 6, dadurch gekennzeichnet, daß das leitende Material von einer Legierung auf Zinnbasis gebildet ist, die das genannte Loch vollständig füllt.

9. Oszillator nach einem der Ansprüche 1 bis 6, dadurch gekennzeichnet, daß das leitende Material von einem leitfähigen Kleber gebildet ist, das das genannte Loch füllt.

10. Oszillator nach Anspruch 2, dadurch gekennzeichnet, daß das genannte Loch eine Kraterform besitzt, deren größere Öffnung sich auf der Außenseite der genannten ersten Platte befindet.

**0 156 146**

Fig. 1

Fig. 2

1

a)

b)

c)

d)

e)

f)

Fig.3